Europäisches Patentamt

European Patent Office

Office européen des brevets

(19)

(11) Publication number : **0 485 122 A1**

(12) **EUROPEAN PATENT APPLICATION**

(21) Application number : **91310115.0**

(22) Date of filing : **01.11.91**

(51) Int. Cl.$^5$ : **C30B 31/16, H01L 21/22**

(30) Priority : **07.11.90 US 610473**

(43) Date of publication of application :
**13.05.92 Bulletin 92/20**

(84) Designated Contracting States :
**DE FR NL**

(71) Applicant : **THE CARBORUNDUM COMPANY**
**200 Public Square, 7A**
**Cleveland, Ohio 44114-2375 (US)**

(72) Inventor : **Dalcin, James R.**
**3480 Wallace Drive**
**Grand Island, New York 14072 (US)**

Inventor : **Rogers, Michael C.**
**6699 Rapids Road**
**Lockport, New York 14094 (US)**
Inventor : **Kim, Young-Sig**
**Chon-Nam University, Kwang-Su**
**Chon-Nam (KR)**
Inventor : **Tressler, Richard E.**
**1040 Boalsburg Road**
**Boalsburg, Pennsylvania 16827 (US)**
Inventor : **Tworek, John L.**
**31 East Bihrwood Drive**
**West Seneca, New York 14224 (US)**
Inventor : **Viswanathan, Lakshminarayan**
**65 Prestonwood Lane**
**East Amherst, New York 14051 (US)**

(74) Representative : **Ryan, Edward Terrence et al**
**BP INTERNATIONAL LIMITED Patents &**
**Agreements Division Chertsey Road**
**Sunbury-on-Thames Middlesex, TW16 7LN**
**(GB)**

(54) **Cerium pentaphosphate planar diffusion source for doping at low temperatures.**

(57)   A cerium pentaphosphate dopant source for the vapor phase transport of phosphorus oxides to a silicon wafer wherein the dopant source dissociates at a low temperature.

EP 0 485 122 A1

FIELD OF THE INVENTION

The present invention relates to a novel phosphorus doping composition that is used for doping semi-conductor elements at low temperatures. The invention relates to a novel cerium pentaphosphate doping source for use at low temperatures.

BACKGROUND OF THE INVENTION

Semiconductor elements have various applications and utilities in the electronic industry and are used as integrated circuits, photodiodes, transistors, solar batteries, rectifiers, radiation detectors, charge particle detectors and other applications. Semiconductor elements have been known in the industry for many years and the term semiconductor element is generally accepted to include semiconductor devices and parts thereof formed of host substrates comprising elements, alloys and intermetallic compounds of silicon, germanium, silicon/germanium, arsenic, gallium, phosphorus, indium and the like. The semiconductor elements can be any convenient or usable shape but are typically commercially used in the form of circular, triangular or rectangular wafers or disks.

In order to achieve the various electrical rectification characteristics, semiconductor elements typically have an active impurity incorporated within the host substrate. The active impurities are classified as donor impurities or acceptor impurities; they include phosphorus, arsenic, antimony, silicon, tellurium, tin and the like and the acceptor impurities include boron, gallium, aluminum, zinc, cadmium and the like.

The semiconductor element may have a region containing an excess of donor impurities yielding an excess of free electrons. This region is termed an impurity doped n-type region. Similarly, a region containing an excess of acceptor impurities which results in the deficit of electrons is termed impurity doped p-type region. The boundary between the p-type and n-type regions is termed n-p or p-n junction. In many applications the uniformity of the impurity distribution within the p or n-type region is critical to the efficiency of the semiconductor element. Further, the sharpness of the p-n or n-p junction may be critical to the efficiency of the semiconductor element. Generally, incorporating various active impurities in the semiconductor elements have been done during preparation of the host substrate or by deposition of the host substrate during manufacture.

Solid diffusion sources employing phosphorus have been developed. U.S.P.N. 3,852,086 discloses a solid diffusion source for phosphorus doping. U.S.P.N. 3,931,056 discloses solid diffusion sources for phosphorus doping containing silicon and zirconium pyrophosphates. U.S.P.N. 4,526,826 discloses foam semiconductor dopant carriers for diffusion doping of semiconductors by the vapor phase transport of an n or p-type dopant, such as phosphorus, arsenic, antimony, boron gallium, aluminum, zinc, silicon, tellerium, tin and cadmium to the semiconductor host substrate. U.S.P.N. 4,175,988 discloses polycrystalline ceramics and dopant hosts containing phosphorus.

Solid phosphorus diffusion sources have been disadvantageous because of the limitation of their temperature ranges.

There have been efforts to make solid phosphorus diffusion sources for low temperature. U.S.P.N. 4,800,175 discloses phosphorus planar dopant sources for low temperature applications. However, the sources have had inconsistent diffusion results at low temperatures and/or were very fragile. A new approach to low temperature solid phosphorus diffusion sources is necessary.

There is a need for planar dopant sources that will deposit phosphorus oxides on silicon wafers by vapor transport at low temperatures and provide uniform doping of silicon at a low sheet resistance for a given temperature.

OBJECTS OF THE INVENTION

It is an object of the present invention to provide a doping composition and a silicon body being doped by the vapor phase transport of phosphorus oxides from the source to the silicon body at low temperatures. Another object is to provide a novel composition containing cerium pentaphosphate for use as a dopant source at low temperatures. A further object of the invention is to provide a cerium pentaphosphate dopant source to dope a silicon body uniformly and having controlled sheet resistance.

These and other objects will become apparent from the following description of the present invention.

SYMMARY OF THE INVENTION

The present invention provides a low temperature dopant source for the vapor phase transport of phosphorus oxides to a silicon body comprising cerium pentaphosphate composition said composition capable of dissociating and depositing in the temperature range of about 800°C to about 975°C.

The present invention also provides a process for doping a silicon body comprising:

a) forming a cerium pentaphosphate dopant source,

b) placing the dopant source with a silicon body to be doped, and

c) maintaining the dopant source and the silicon body at a temperature in the range of about 800°C to about 975°C to vapor phase transport phosphorus oxides from the dopant source to diffuse into the silicon body.


## DETAILED DESCRIPTION OF THE INVENTION

It has been discovered that cerium pentaphosphate is particularly suitable as a solid phosphorus diffusion source for doping of semiconductor elements by vapor phase deposition of phosphorus. The cerium pentaphosphate composition evolves phosphorus oxides when heated to temperatures in the range of about 800°C to about 975°C. The reaction is generally described as follows:

$$CeP_5O_{14} \rightarrow CeOP_3O_9 + P_2O_5$$

The cerium pentaphosphate composition of the instant invention can also be prepared by the method found in Par Muriel Bagieu-Beucher et Duc Tranqui: Les Ultraphosphates de Terres Rares et D'yttrium du Type $TP_5O_{14}$, (The Ultraphosphates of Rare Earth and of Yttrium of the $TP_5O_{14}$) Bull. Soc. Fr. Mineral. Cristallogr. (1970), 83, 505-508, incorporated by reference, for showing a preparation of a cerium pentaphosphate composition. The article discloses a method of preparing ultraphosphates by a mixture of rare earth oxide and an orthophosphoric acid in excess which is calcined for one or two days at temperatures between 350°C and 750°C forming crystals. Further, the ultraphosphates can be synthesized in a polycrystalline state by calcining for a day at a temperature of about 500°C, a mixture in stochiometric proportions of rare earth oxide and biammonium phosphate.

A typical procedure to prepare the cerium pentaphosphate composition of the instant invention is as follows: Cerium oxide and ammonium dyhydrogen phosphate are mixed, ballmilled and then calcined to initiate a solid state reaction resulting in cerium pentaphosphate powder. The cerium pentaphosphate powder is then prepared into source wafers for the phosphorus doping of the semiconductor elements. Generally, the source wafer is prepared by making a slurry of the cerium pentaphosphate powder and water. Then the binding agents and/or additives are added to slurry. The mixture is then heated resulting in the dopant source.

Generally, the dopant source of this invention can be used in any appropriate solid form. The solid dopant can be formed in any convenient size and shape, but typically it is formed in substantially the same or slightly larger size and shape as a semiconductor body or wafer that it will be doping. The dopant can be used in any appropriate form and/or on any universal substrate including but not limited to powders of various coarseness; particulates; molded bodies; pressed bodies; wafers; ceramic foams; for example, silicon carbide foam, silicon nitride foam and the like; glass bodies; boats; crucibles; ceramic porous bodies; coated onto a reaction vessel and the like. The particulate of the dopant source can be formed by milling, grinding, jet milling, water milling, screening and the like. The cerium pentaphosphate if employed on a universal substrate can be applied by conventional methods such as dipping, coating, spraying and the like. The rate of doping and lifetime of the product is dependent on the form of the source wafer employed in the diffusion process.

The cerium pentaphosphate source may be used with binding agents at about 0% by weight to about 20% by weight of the dopant, preferably 5% by weight to about 10% by weight of the dopant. The weight percent of the binder is dependent upon the annealing time, milling time, manufacture of the source wafer, cost, purity and the like. Typical binders include but are not limited to inorganic binders such as silicates, colloidal silica, colloidal alumina, colloidal aluminates, colloidal silicates, colloidal silicon oxide, crystalline silica, silicic acid, phosphosilica gels, metallic oxides and the like.

Other additive/dispersants may also be included such as surfactants that vaporize off during processing such as sodium-free/non-ionic surfactants and include, but are not limited to surfactants sold under the trade names Tergitol (available from Union Carbide Co.), Nyacol, Nekal and the like. Other additives include fluxing agents, which leave a residue in the doping source that may enhance the phosphorus to vaporize and include, but are not limited to barium oxide, cesium chloride and the like. The weight percent of the additives/dispersants is dependent on the type and purpose of additives such as to control viscosity of the source wafer or achieve sprayability of the source wafer and are from about 0% by weight to about 10% by weight and generally less than 1% by weight.

The binding agent and/or additive/dispersant is employed to provide strength and coating integrity and control of doping profiles in the silicon as evidenced by sheet resistance. It is important that the amount and type of any binder and/or additive/dispersant does not adversely affect the phosphorus doping or contribute undesirable diffusible impurities which adversely affect the properties of the dopant and/or the semiconductor body.

Generally, the method of doping of the semi-conductor body such as silicon comprises diffusing phosphorus into a semi-conductor silicon body by positioning at least one silicon body, in the vicinity of the dopant source, in the furnace and then subjecting the silicon body and dopant source to a temperature in the range of 800°C to 975°C and preferably 825°C and 950°C and under controlled atmosphere. The dopant source and silicon body may be placed in vessels such as diffusion boats, molded bodies and the like. The silicon body may have appropriate conventional masking patterns typical to the semiconductor industry. At these temperatures, the dopant source liberates phosphorus oxide vapors in particular $P_2O_5$ vapors which contact the surface of the silicon body that requires doping. This process is conducted for a sufficient period of time to permit the diffusion of the phosphorus into at least a portion of the surface of the silicon body to form a diffused region therein. Generally, the doping occurs in the range of about 10 minutes to about 2 hours and preferably in the range of about 15 minutes to about 1 hour. The doping process is further controlled by the use of free-flowing inert carrier gases such as argon, nitrogen or the like. The carrier gas does not enter into a chemical reaction between the phosphorus vapors and the silicon surface.

The invention is further illustrated by the following examples, although it is understood that the examples are intended merely for purpose of illustration and are not intended to limit the scope of the invention.

## SPECIFIC EMBODIMENTS OF THE INVENTION

Synthesis of Cerium Pentaphosphate Powder

Cerium pentaphosphate was prepared with rare earth oxide of cerium oxide and ammonium dyhydrogen phosphate. The synthesis procedure was as follows:

1) about 2770g of ammonium dyhydrogen phosphate was mixed with about 753g cerium oxide and 10 lb of standard milling medium, and ball milled for about 20hrs at about 50rpm's;

2) the firing process was either a continuous firing process or a low/high firing process.

a) the continuous firing process was as follows:

| | Step | Temp. (°C) | Time (hrs.) | Ambient |
|---|---|---|---|---|
| a) | Hold | 60 | 0.50 | Air |
| b) | Ramp/Hold | 150 | 1.50 | Air |
| c) | Ramp/Hold | 200 | 0.50 | Air |
| d) | Ramp/Hold | 250 | 0.50 | Air |
| e) | Ramp/Hold | 300 | 0.50 | Air |
| f) | Ramp/Hold | 350 | 0.50 | Air |
| g) | Ramp/Hold | 400 | 0.50 | Air |
| h) | Ramp/Hold | 450 | 0.50 | Air |
| i) | Ramp/Hold | 500 | 0.50 | Air |
| j) | Hold | 500 | 21.00 | Air |
| k) | Ramp/Hold | 550 | 0.50 | Air |
| l) | Ramp/Hold | 600 | 0.50 | Air |
| m) | Ramp/Hold | 650 | 0.50 | Air |
| n) | Ramp/Hold | 700 | 0.50 | Air |
| o) | Hold | 700 | 48.00 | Air |
| p) | Free Ramp | RT | 24.00 | Air |

b) the low/high firing process was as follows:

i) Low Firing Processing:

| Step | | Temp. (°C) | Time (hrs.) | Ambient |
|---|---|---|---|---|
| a) | Hold | 60 | 1.50 | Air |
| b) | Ramp/Hold | 150 | 1.50 | Air |
| c) | Ramp/Hold | 200 | 0.50 | Air |
| d) | Ramp/Hold | 250 | 0.50 | Air |
| e) | Ramp/Hold | 300 | 0.50 | Air |
| f) | Ramp/Hold | 350 | 0.50 | Air |
| g) | Ramp/Hold | 400 | 0.50 | Air |
| h) | Ramp/Hold | 450 | 0.50 | Air |
| i) | Ramp/Hold | 500 | 0.25 | Air |
| j) | Hold | 500 | 24.00 | Air |
| k) | Free Ramp | RT | 24.00 | Air |

ii) The soft material was scraped from the reaction box, ground to a finer powder and then returned to the reaction box.
iii) High Firing Processing:

| Step | | Temp. (°C) | Time (hrs.) | Ambient |
|---|---|---|---|---|
| a) | Hold | 60 | 0.50 | Air |
| b) | Ramp/Hold | 150 | 0.25 | Air |
| c) | Ramp/Hold | 700 | 2.75 | Air |
| d) | Hold | 700 | 24.00 | Air |
| e) | Free Ramp | RT | 24.00 | Air |

3) the composition was furnace cooled and the soft material, i.e. cerium pentaphosphate powder was separated and removed from the furnace,
4) the synthesis process can take place on a universal substrate wafer (i.e. silicon carbide foam wafer or its equivalent).

Synthesis of Cerium Pentaphosphate Source Wafers

Cerium pentaphosphate wafers were prepared for phosphorus doping experiments with the cerium pentaphosphate powder. The procedures for the preparation for spray coating cerium pentaphosphate source wafers were as follows:
1) About 500g of cerium pentaphosphate powder was mixed with about 61g of colloidal silica in 800g of water, about 2.5g TMN-3 Surfactant (0.5g of WP-13 Surfactant could be used in place of the TMN-3 Surfactant) and about 3.8g of TMN-6 Surfactant (surfactants available from Union Carbide, Tergitol Nonionic Surfactants) were added to the mix to make a slurry as follows:
   a) The cerium pentaphosphate powder and water were milled for about 16 hours;
   b) the colloidal silica was added and milled in the cerium pentaphosphate water mixture for about 1 hour; and
   c) the surfactants were then added to the slurry mixture and milled for about 45 minutes;
2) the cerium pentaphosphate slurry mixture was spray coated on the silicon carbide substrates; and
3) the spray coated silicon carbide wafer was then placed in a furnace at about 850°C for about 1 hour in air.
The procedure for dip coating the cerium pentaphosphate source wafers were as follows:
1) About 300g of cerium pentaphosphate powder was mixed with about 548g of water and about 15g of phosphorus silicate gel,
2) the powder, water and gel mixture were milled for about 14 hours,
3) the mixture was then stir mixed with about 200g of silicon pyrophosphate (PH-1000n - trade name) slurry,
4) the mixture slurry was then used to dip coat the silicon carbide wafers with a single drying, and
5) the dip coated silicon carbide wafers were sintered at about 850°C for about 1 hour in air in a covered fused silica container.

## Diffusion Procedure

The source wafer and silicon carbide wafer were placed in a boat and were pushed into a furnace. The wafers were preheated to about 700°C for about 10 minutes in a nitrogen atmosphere of about 5 1/min. After the wafers were preheated, they remained in the furnace at about 700°C for about 10 minutes to stabilize. The furnace was ramped up to about 850°C, which took about 20 minutes. The wafers were then heated at about 850°C for about 60 minutes in the nitrogen atmosphere for transfer of the phosphorus oxides to the silicon to occur. Then the furnace was ramped down to about 700°C, which took about 20 minutes. The boat with the wafers was then removed from the furnace, which took about 10 minutes.

The source wafers and silicon carbide wafers had a diameter of about 75 millimeters and the diffusion tube had a diameter of about 165 millimeters.

## Control

Controls were used of The Carborundum Company PH-950 (trade name) dopant source, a silicon pyrophosphate PH-1000n (trade name) dopant source, both high temperature phosphate dopant sources.

## Thermalanalysis

Thermogravimetric Analysis (TGA) was performed on the source wafers to measure the weight change, which indicates where the dopant evolves from the dopant source. TGA is a method of studying the chemical reactions occurring to the source wafers within the furnace. In a TGA, the weight of a specimen is monitored as it is taken from various temperature processes. The results are presented in Figure I for cerium pentaphosphate powder at 800°C, 850°C and about 950°C in argon and in Figure II for PH-1000n at 800°C, 825°C and 850°C in argon.

The cerium pentaphosphate shows small weight loss at 800°C, measurable weight loss at 850°C and rapid weight loss at 950°C. As shown in Figure II, the weight loss of PH-1000n was lower than the cerium pentaphosphate at the same temperatures. A comparison shows that there is about a 100°C temperature difference achieving comparable rate of decomposition of the source wafer.

## Glass Thickness

The glass thickness test demonstrates the formation of phosphosilicate glass on the silicon body which should be at least equal to or greater than 200Å, and is a prerequisite for effective doping. Diffusion runs were performed with cerium pentaphosphate, as shown in Table I and Figure III. This demonstrates doping caracteristics at low temperatures.

## Sheet Resistance

The sheet resistance test shows that the electrically active species of phosphorus has gone into the silicon. The lower the sheet resistance the more electrically active phosphorus has penetrated the silicon. One and two-hour diffusion runs were performed with cerium pentaphosphate solid wafers. Table II and Figure IV show the sheet resistance for cerium pentaphosphate. This demonstrates doping characteristics at low temperatures.

## Lifetime

The lifetime of the cerium pentaphosphate source was studied over 200 hours of use time at 850°C doping runs. The glass thickness as shown in Figure V decreased after the initial increase as use time increased. This demonstrates that the glass thickness after 200 hours of use is still over 200Å, which is the minimal thickness required to satisfactorily dope silicon. Figure VI shows that the sheet resistance is nearly constant which demonstrates controlled doping of silicon for a minimum of 220 hours of use time.

Although the invention has been described in detail through the proceeding examples, these examples are for the purpose of illustration only and it is understood that variations and modifications can be made by one skilled in the art without departing from the spirit and scope of the invention.

CERIUM PENTAPHOSPHATE DATA
DIFFUSION RESULTS

TABLE I

Oxide (angstroms)

| Time | Temperature (°C) | | | |
|------|------|------|------|------|
| (minutes) | 800 | 825 | 850 | 875 |
| 15 | ---- | 160 | 305 | 520 |
| 30 | ---- | 240 | 455 | 650 |
| 45 | ---- | 320 | 530 | 760 |
| 60 | 250 | 380 | 590 | 755 |
| 120 | 350 | ---- | ---- | ---- |

TABLE II

Sheet Resistance (ohms/square)

| Time | Temperature (°C) | | | |
|------|------|------|------|------|
| (minutes) | 800 | 825 | 850 | 875 |
| 15 | ---- | 123 | 67 | 42 |
| 30 | ---- | 79 | 47 | 30 |
| 45 | ---- | 63 | 40 | 25 |
| 60 | 86 | 54 | 35 | 21 |
| 120 | 60 | 37 | 23 | 15 |

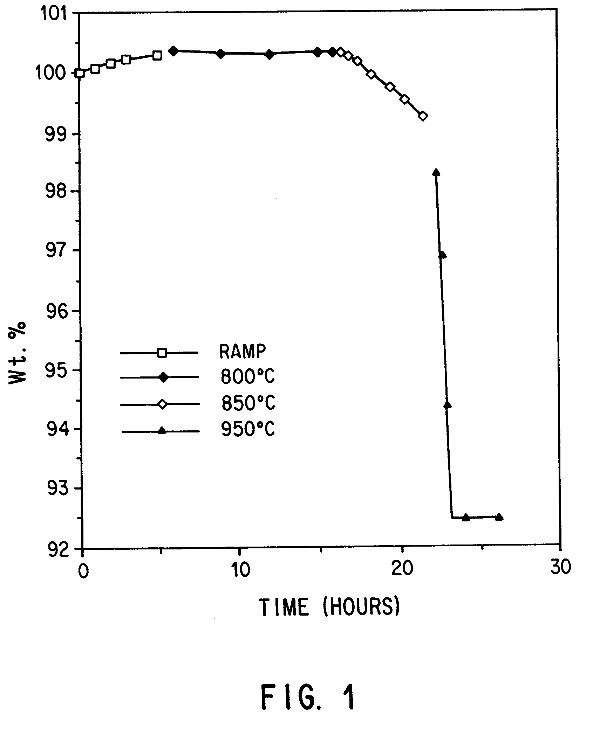

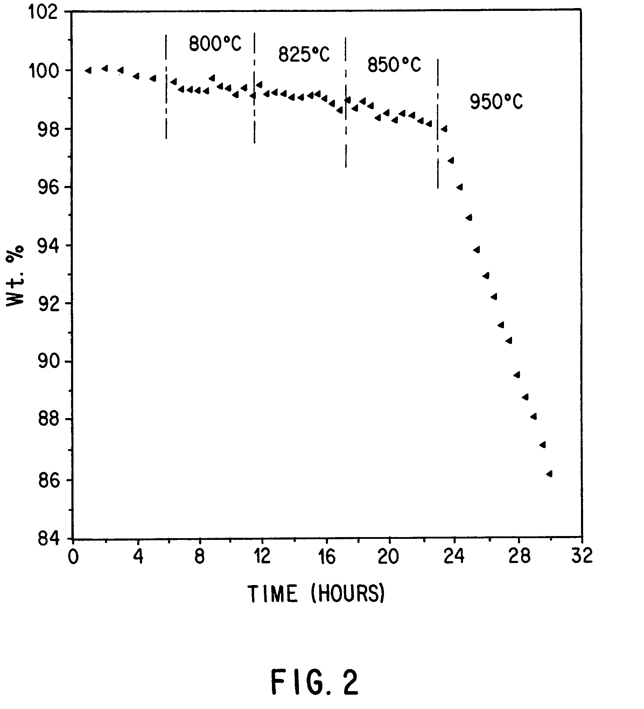

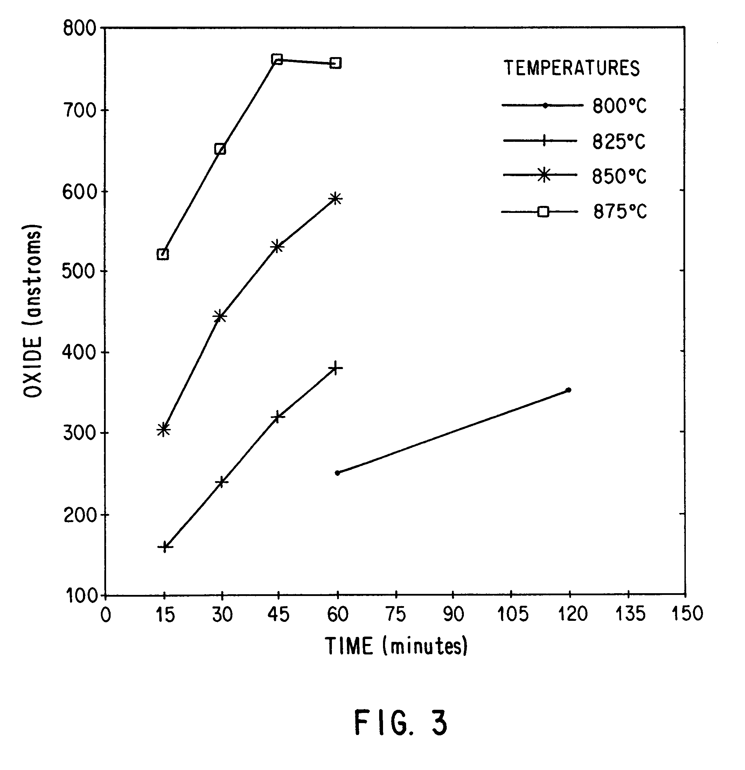

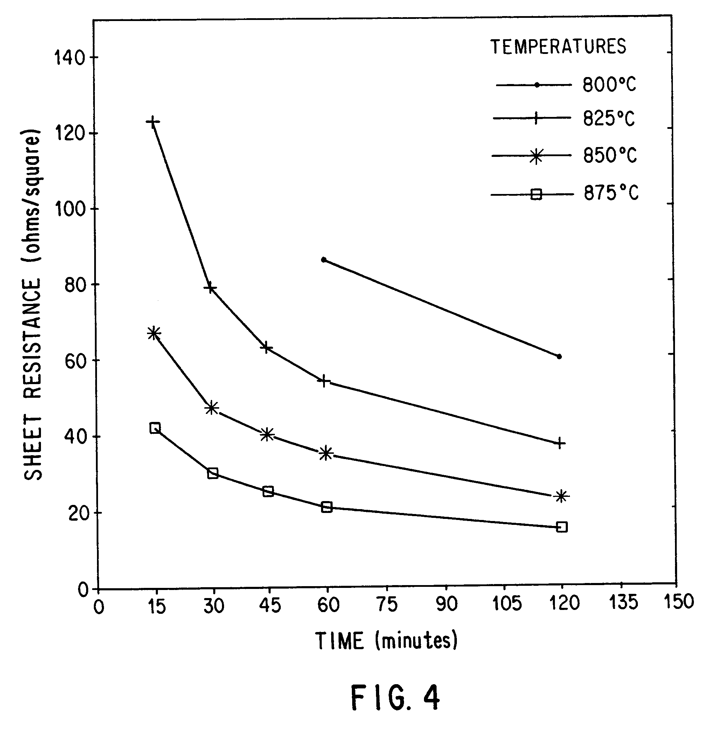

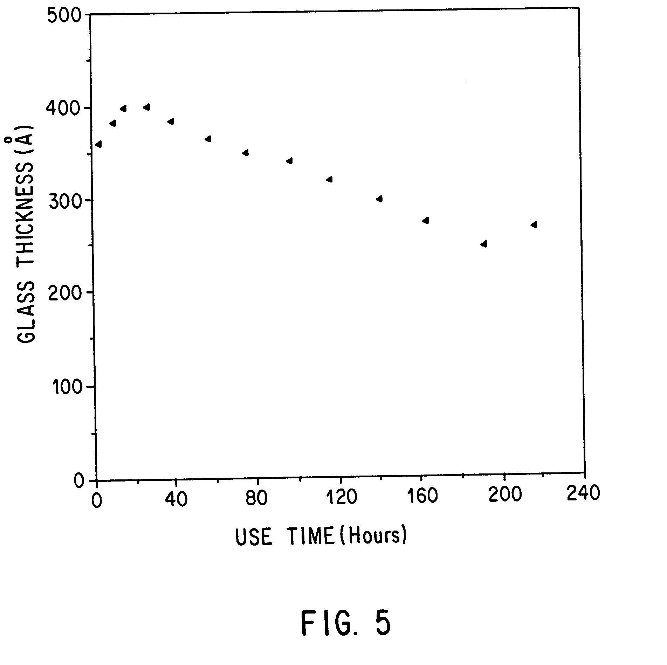

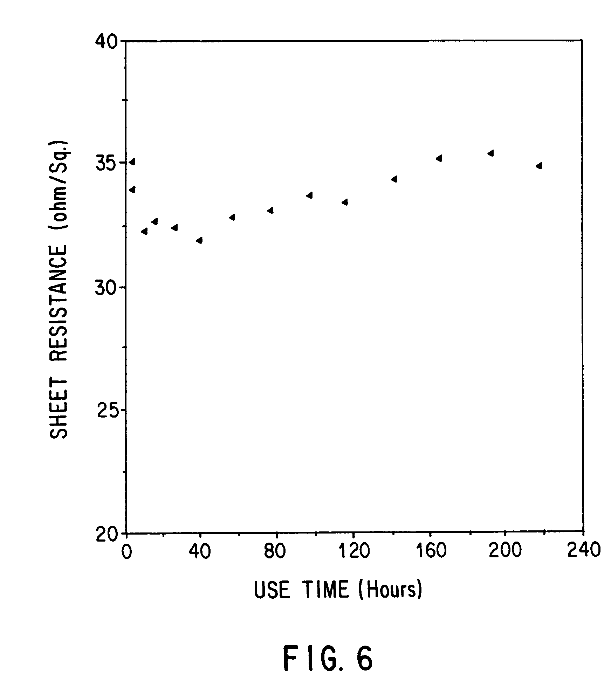

**Claims**

1. A low temperature dopant source for the vapor phase transport of phosphorus oxides to a silicon body comprising cerium pentaphosphate composition, said composition capable of dissociating in the temperature range of about 800°C to about 975°C.

2. The dopant source of claim 1 wherein the dopant source is in a solid form and is in a form selected from the group consisting of powders of varying coarsenesses; particulates; molded bodies; pressed bodies; wafers; ceramic foams selected from a group consisting of of silicon carbide foam, silicon nitride foam and combinations thereof; glass bodies; boats; crucibles; ceramic porous bodies; coated onto a reaction vessel and combinations thereof.

3. The dopant source of claim 1 wherein the particulate of the dopant source can be formed by milling, grinding, jet-milling, water-milling, screening and combinations thereof.

4. The dopant source of claim 2 wherein the cerium pentaphosphate is employed on a universal substrate and wherein it is applied onto such universal substrate by a method selected from the group consisting of dipping coating, spraying and combinations thereof.

5. The dopant source of claim 1 wherein the dopant is employed with binding agents selected from the group consisting of silicates, colloidal silicates, colloidal alumina, colloidal aluminates, colloidal silicon oxide, cyrstalline silica, silicic acid, phosphosilicate gels, metallic oxides and combinations thereof; and with additives and surfactants selected from the group consisting of surfactants, in particular sodium-free/non-ionic surfactants and combinations thereof, fluxing agents, in particular barium oxide, cesium chloride and combinations thereof.

FIG. 1

FIG. 2

FIG. 3

FIG. 4

FIG. 5

FIG. 6

| European Patent Office | EUROPEAN SEARCH REPORT | Application Number |
|---|---|---|
| | | EP 91 31 0115 |

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | US-A-4 033 790 (GUNJIGAKE ET AL)<br>* example 2 *<br>--- | 1-5 | C30B31/16<br>H01L21/22 |
| A,D | US-A-3 931 056 (MYLES ET AL)<br>--- | | |
| A | US-A-3 998 668 (FLORENCE ET AL)<br>--- | | |
| A | US-A-3 923 563 (VENKATU)<br>----- | | |
| | | | **TECHNICAL FIELDS SEARCHED (Int. Cl.5 )**<br><br>C30B<br>H01L |

The present search report has been drawn up for all claims

| Place of search | Date of completion of the search | Examiner |
|---|---|---|
| THE HAGUE | 25 FEBRUARY 1992 | COOK S.D. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

                                                 
& : member of the same patent family, corresponding document

EPO FORM 1503 03.82 (P0401)